# EUROPEAN PATENT APPLICATION

(11) **EP 4 411 787 A1**
(43) Date of publication of application: **07.08.2024**
(21) Application number: 22876187.0
(22) Date of filing: 27.09.2022
(51) Int. Cl.: H01L 21/02

(54) **METHOD FOR SEPARATING BONDED WAFER**

(30) Priority: 29.09.2021 JP 2021159760
(71) Applicant: Shin-Etsu Handotai Co., Ltd., Tokyo 100-0004 (JP); SHIN-ETSU CHEMICAL CO., LTD., Tokyo 1000005 (JP)
(72) Inventor: ISHIZAKI, Junya, Annaka-shi, Gunma 379-0196 (JP); YAMADA, Masato, Tokyo 100-0004 (JP); OGAWA, Yoshinori, Tokyo 100-0005 (JP)
(74) Representative: Meissner Bolte Partnerschaft mbB
(86) International application number: PCT/JP2022/035852
(87) International publication number: WO 2023/054321

(57) **Abstract**

The present invention is a method for separating a bonded wafer, the method comprises separating a support from a bonded wafer which comprises a device structure portion having two or more electrodes with different polarities on one side of an epitaxial functional layer, and the device structure portion being bonded to a support made of a foreign substrate using a curable bonding material, wherein, by irradiating the bonded wafer with a laser beam, the curable bonding material and/or at least a portion of the surface of the device structure portion that comes into contact with the curable bonding material absorb(s) the laser beam to decompose the curable bonding material and/or the surface of the device structure portion, and thus the device structure portion and the support are separated. As a result, it is provided a method for separating a bonded wafer with a high survival rate of device structure portion in the separation of a bonded wafer that is firmly bonded with a curable bonding material, as a bonded wafer, which has the device structure portion having two or more electrodes with different polarities on one surface of an epitaxial functional layer and the device structure portion is bonded to a support made of a foreign substrate with the curable bonding material.

## Description

### TECHNICAL FIELD

The present invention relates to a method for separating a bonded wafer, and particularly to a method for separating a bonded wafer in which an epitaxial wafer is bonded to a foreign substrate.

### BACKGROUND ART

A technique of separating only an epitaxial functional layer from a starting substrate and transferring it to another substrate is an important technique for alleviating constraints caused by physical properties of starting substrate and increasing degree of freedom in designing device systems.

In order to realize this transfer, a technique is required to realize the transfer by removing the starting substrate after bonding the epitaxial functional layer to a permanent substrate.

Patent Document 1 discloses a technique of bonding a semiconductor epitaxial substrate and a temporary support substrate by thermocompression via a dielectric layer, and a technique of separating the temporary support substrate and the epitaxial functional layer by wet etching.

Patent Document 2 discloses a technique in which a transparent conductive layer is inserted between an adhesive layer and a functional layer as one form of bonding, although it is not directly related to improving bondability.

However, Patent Document 1 discloses a technique of thermocompression bonding a semiconductor epitaxial substrate and a temporary support substrate via a dielectric layer, and a technique of separating the temporary support substrate and an epitaxial functional layer by wet etching. In order to maintain temporary support, there is a restriction that thermal conditions must be below a certain level. Therefore, there are restrictions on manufacturing devices in the epitaxial functional layer after removing the starting substrate.

Furthermore, when performing a device process after removing the starting substrate, a thermal process is essential to obtain ohmic contact. However, if thermal history is applied to create ohmic contact while bonding using an organic bonding material, temporary support becomes permanent bonding (a bond that is stronger than temporary support), making separation difficult.

### CITATION LIST

### PATENT LITERATURE

Patent Document 1: JP 2021-27301 A
Patent Document 2: JP 2004-158823 A

### SUMMARY OF INVENTION

### TECHNICAL PROBLEM

The present invention has been made in view of the above problems, and an object is to provide a method for separating a bonded wafer with a high survival rate of device structure portion in the separation of a bonded wafer that is firmly bonded with a curable bonding material, as a bonded wafer, which has the device structure portion having two or more electrodes with different polarities on one surface of an epitaxial functional layer and the device structure portion is bonded to a support made of a foreign substrate with the curable bonding material.

### SOLUTION TO PROBLEM

The present invention has been made to achieve the above object and provides a method for separating a bonded wafer, the method comprises separating a support from a bonded wafer which comprises a device structure portion having two or more electrodes with different polarities on one side of an epitaxial functional layer, and the device structure portion being bonded to a support made of a foreign substrate using a curable bonding material, wherein, by irradiating the bonded wafer with a laser beam, the curable bonding material and/or at least a portion of the surface of the device structure portion that comes into contact with the curable bonding material absorb(s) the laser beam to decompose the curable bonding material and/or the surface of the device structure portion, and thus the device structure portion and the support are separated.

In such a method for separating a bonded wafer of the present invention, the support can be easily separated from the device structure portion by irradiating with laser beam. Therefore, compared to removing the support by machining or etching, the survival rate of the device structure portion (the rate at which the device structure portion remains without being destroyed) can be increased.

Further, in the method for separating the bonded wafer of the present invention, the epitaxial functional layer may have a light emitting device structure.

Further, the epitaxial functional layer may include an AlGaInP-based material.

The present invention can be suitably employed in separating a bonded wafer having such structures.

Further, in the method for separating the bonded wafer of the present invention, it is preferable that the curable bonding material has a curable property any one of thermosetting, UV curability, and room temperature curability.

In this case, the curable bonding material preferably contains one of benzocyclobutene, polyimide, fluororesin, epoxy resin, and silicone resin.

The method for separating the bonded wafer of the present invention is particularly suitable when such a curable bonding material is used.

Further, it is preferable that the epitaxial functional layer has a starting substrate for epitaxial growth has been removed.

The method for separating the bonded wafer of the present invention can be suitably applied to separation of a bonded wafer from which the starting substrate has been removed.

Further, it is preferable that the foreign substrate is made of one of sapphire, SiC, synthetic quartz, quartz, glass, LiTaO₃, and LiNbO₃.

Such a foreign substrate can be selected to have high laser transparency and is suitable for the method for separating the bonded wafer of the present invention.

Moreover, it is preferable that the laser beam is an excimer laser.

In this way, by using an excimer laser as the laser beam, the bonded wafer can be separated more reliably.

Further, before the laser beam irradiation, it is preferable that a temporary support substrate coated with an adhesive is adhered to the surface of the epitaxial functional layer of the bonded wafer opposite to the foreign substrate.

At this time, it is preferable that the adhesive is silicone.

Preferably, the temporary support substrate is made of any one of sapphire, SiC, synthetic quartz, quartz, glass, LiTaO₃, and LiNbO₃.

By using such a temporary support substrate and adhesive, the bonded wafer can be separated more smoothly.

### ADVANTAGEOUS EFFECTS OF INVENTION

In the method for separating a bonded wafer of the present invention, the support can be easily separated from the device structure portion by irradiating with laser beam. Separation by laser beam irradiation requires less stress on the device. Therefore, compared to removing the support by machining or etching, the survival rate of the device structure portion (the rate at which the device structure portion remains without being destroyed) can be increased.

### BRIEF DESCRIPTION OF DRAWINGS

FIG. 1 is a schematic diagram illustrating a step of manufacturing an epitaxial wafer with an epitaxial functional layer on a starting substrate as a part of a process of manufacturing a bonded wafer;
FIG. 2 is a schematic diagram showing a step of bonding an epitaxial wafer and a foreign substrate as a part of a process of manufacturing a bonded wafer;
FIG. 3 is a schematic diagram showing a step of removing a starting substrate as a part of a process of manufacturing a bonded wafer;
FIG. 4 is a schematic diagram showing a step of forming a first electrode as a part of a process of manufacturing a bonded wafer;
FIG. 5 is a schematic diagram showing a step of forming a notch as a part of a process of manufacturing a bonded wafer;
FIG. 6 is a schematic diagram showing a step of forming a second electrode as a part of a process of manufacturing a bonded wafer;
FIG. 7 is a schematic diagram showing a step of bonding a bonded wafer and a temporary support substrate before separating the bonded wafer;
FIG. 8 is a schematic diagram showing an example of the first embodiment of the method for separating a bonded wafer of the present invention; and
FIG. 9 is a schematic diagram showing an example of a second embodiment of the method for separating a bonded wafer of the present invention.

### DESCRIPTION OF EMBODIMENTS

Hereinafter, the present invention will be explained in detail, but the present invention is not limited thereto.

The present invention is a method for separating a bonded wafer, the method comprises separating a support from a bonded wafer which comprises a device structure portion having two or more electrodes with different polarities on one side of an epitaxial functional layer, and the device structure portion being bonded to a support made of a foreign substrate using a curable bonding material, wherein, by irradiating the bonded wafer with a laser beam, the curable bonding material and/or at least a portion of the surface of the device structure portion that comes into contact with the curable bonding material absorb(s) the laser beam to decompose the curable bonding material and/or the surface of the device structure portion, and thus the device structure portion and the support are separated.

As described above, a bonded wafer to which the separation method of the present invention can be applied is a bonded wafer which has the device structure portion having two or more electrodes with different polarities on one surface of an epitaxial functional layer and the device structure portion is bonded to a support made of a foreign substrate with the curable bonding material. This bonded wafer can be produced, for example, as follows, but is not limited thereto.

### [First embodiment]

In the first embodiment, a case where silicone resin is used as the curable bonding material will be mainly explained.

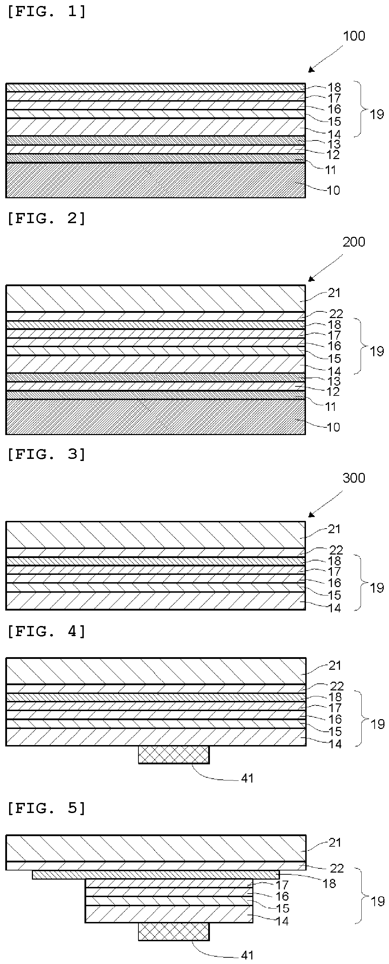

First, as shown in FIG. 1, epitaxial growth is sequentially performed on a starting substrate 10 to form each layer. This produces an epitaxial functional layer. More specifically, each layer can be epitaxially grown as follows. As shown in FIG. 1, after preparing a first conductivity type GaAs starting substrate 10, a first conductivity type GaAs buffer layer 11 is laminated, and then a first conductivity type GaInP first etch stop layer 12, for example 0.3 µm, a first conductivity type GaAs second etch stop layer 13, for example 0.3 µm, a first conductivity type AlGaInP first cladding layer 14, for example 1.0 µm, a non-doped AlGaInP active layer 15, a second conductivity type AlGaInP second cladding layer 16, for example, 1.0 um, a second conductivity type GaInP intermediate layer 17, for example 0.1 um, and a second conductivity type GaP window layer 18, for example 4 µm, can be grown sequentially. In this way, an epitaxial wafer 100 having a light emitting device structure as the epitaxial functional layer 19 is prepared. Here, a portion from the AlGaInP first cladding layer 14 to the AlGaInP second cladding layer 16 is referred to as a DH structure (double heterostructure) portion.

Next, as shown in FIG. 2, the epitaxial wafer 100 and a foreign substrate 21 are bonded using a curable bonding material 22. The foreign substrate 21 serves as a support for the bonded wafer. More specifically, the bonding can be performed as follows. As shown in FIG. 2, a silicone resin is spin-coated as a curable bonding material (thermosetting bonding member) 22 onto an epitaxial wafer 100, and a sapphire wafer, which is the foreign substrate 21, is stacked facing each other and bonded by thermocompression. In this way, the epitaxial wafer 100 and the sapphire wafer, which is the foreign substrate 21, are bonded via a silicone resin, which is the curable bonding material 22. In this way, the epitaxial wafer bonded substrate 200 is manufactured. When applying the silicone resin by spin coating, the designed film thickness can be, for example, about 1.0 µm.

Note that the method is not limited to spin coating the curable bonding material 22 directly on the epitaxial wafer 100, and the same effect can be obtained even if spin coating is performed after laminating one or more transparent films on the epitaxial wafer 100. The transparent film may have a structure including one or more layers of an insulating film such as SiO₂ or SiNₓ, or a transparent conductive film such as indium oxide, tin oxide, or ITO (indium tin oxide).

Furthermore, the material of the foreign substrate 21 is not limited to sapphire, and any material can be selected as long as it ensures flatness and has a low absorption rate of laser light. In addition to sapphire, SiC, synthetic quartz, quartz (natural quartz), glass, LiTaO₃, LiNbO₃, etc. can be selected.

Further, the curable bonding material 22 is not limited to silicone resin, and any material can be selected as long as it has curability, especially thermosetting. In addition to silicone resin, fluororesin or the like may be used.

Next, as shown in FIG. 3, the starting substrate 10 is removed, leaving the epitaxial functional layer 19 on the foreign substrate 21. More specifically, the removal can be performed as follows. As shown in FIG. 3, the GaAs starting substrate 10 (and the GaAs buffer layer 11) is removed by wet etching using a selective etching solution such as ammonia peroxide (a mixture of aqueous ammonia and hydrogen peroxide), and the GaInP first etch stop layer 12 is exposed. Next, the etchant is switched to hydrochloric acid type to selectively remove the GaInP first etch stop layer 12 and expose the GaAs second etch stop layer 13. Next, the etchant is switched to a sulfuric acid hydrogen peroxide type to selectively remove the GaAs second etch stop layer 13 and expose the first cladding layer 14. By performing the above processing, a bonded substrate 300 that holds the epitaxial functional layer 19 (more specifically, the DH layer (from the AlGaInP first cladding layer 14 to the AlGaInP second cladding layer 16) and the window layer 18) is manufactured.

In addition, here, as the thickness of the curable bonding material 22, a silicone resin thickness of 1.0 um is illustrated, but it is not limited to this thickness and similar effect of this can be obtained when it may be thinner or thicker than this thickness. However, since the silicone resin is formed by spin coating, if it is too thin, the area yield after the bonding process tends to decrease. In order to maintain an area yield of 90% or more after bonding, it is preferable to design the adhesive layer thickness to be 0.05 um or more. Moreover, if it is sufficient to maintain a bonding area yield of 70% or more, it is sufficient to design a silicone resin with a thickness of 0.01 um or more. However, from the viewpoint of economic rationality, it is preferable to set the film thickness to 10 um or less.

Next, as shown in FIG. 4, a first electrode 41 is formed in a partial region of the first conductivity type AlGaInP first cladding layer 14. The first electrode 41 is preferably made of a highly reflective metal, and may be made of an Au-based electrode. For the first electrode 41, for example, AuBe-based metal can be used as the metal in contact with the AlGaInP first cladding layer 14.

Next, as shown in FIG. 5, after the first electrode 41 is formed, a part of the first conductivity type AlGaInP first cladding layer 14 other than the region where the first electrode 41 is formed is cut out by a method such as dry etching, the second conductivity type GaP window layer 18 is exposed in the notch.

Although FIG. 5 illustrates the case where only the semiconductor layer portion is cut out, the cutout is not limited to the case where only the semiconductor layer portion is cut out, and cutting may be performed up to the curable bonding material 22 (silicone resin), or it is also possible to cut out up to parts of the foreign substrate 21.

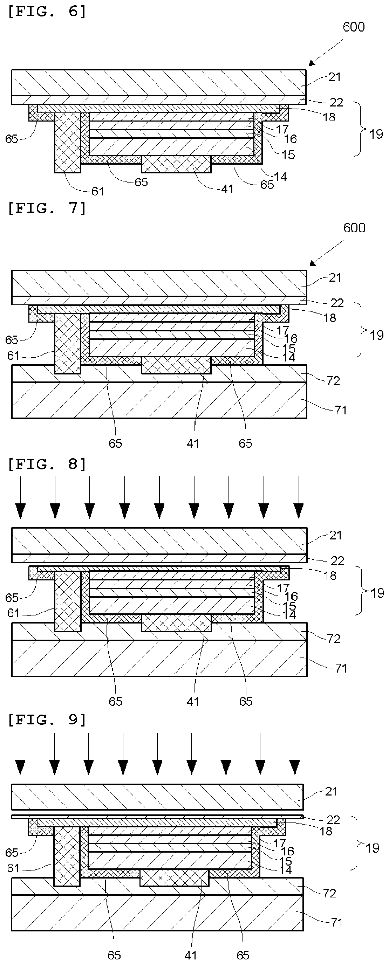

Next, as shown in FIG. 6, the side surfaces are covered with a passivation (PSV) film 65. Furthermore, a bonded substrate having a device structure portion in which a second electrode 61 is formed in the exposed region is manufactured. It is preferable that the second electrode 61 uses a highly reflective metal. Specifically, Au-based materials can be used, and AuSi-based materials are preferred. Note that, as described above, the PSV film 65 may be formed before the second electrode 61 is formed, or the PSV film 65 may be formed after the second electrode 61 is formed. Further, the PSV film 65 itself does not necessarily have to be formed. After forming the first and second electrodes, RTA heat treatment is performed at 400 °C for 5 minutes, for example, in order to obtain ohmic contact.

In this way, a bonded wafer (bonded substrate having a device structure portion) 600 in which the device structure portion having two or more electrodes (the first electrode 41 and the second electrode 61) with different polarities on one surface of the epitaxial functional layer 19 is bonded to the foreign substrate 21 with the curable bonding material 22 is fabricated.

The present invention is a method for separating a bonded wafer, in which a support made of a foreign substrate 21 is separated from the bonded wafer 600, by irradiating the bonded wafer 600 with laser beam, the curable bonding material 22 and/or at least a portion of the surface of the device structure portion that comes into contact with the curable bonding material 22 absorbs the laser light, and the curable bonding material 22 and/or a portion of the surface of the device structure portion decomposes to separate the device structure portion and the support. In the first embodiment, an aspect based on decomposition of the surface of the device structure portion will be mainly described.

First, as shown in FIG. 7, it is preferable to adhere a temporary support substrate 71 coated with an adhesive 72 to the surface of the epitaxial functional layer 19 on the side opposite to the foreign substrate 21 of the bonded wafer before irradiating the laser beam. Specifically, this adhesion is as follows. First, as shown in FIG. 7, a temporary support substrate 71 is prepared by coating a layered silicone adhesive 72 on a synthetic quartz wafer as a temporary support substrate 71, and the bonded wafer 600 and temporary support substrate 71 are placed opposite each other and pressed down and stuck to the adhesive.

Note that the temporary support substrate 71 is not limited to synthetic quartz, but sapphire, quartz (natural quartz), glass, SiC, LiTaO₃, LiNbO₃, or the like can be used.

Next, as shown in FIG. 8, an excimer laser is irradiated from the side of the foreign substrate 21, and the laser beam that has passed through the foreign substrate (sapphire substrate) 21 and the curable bonding material (silicone resin bonding layer) 22 is absorbed at the GaP window layer 18 and decomposition (ablation) to separate the foreign substrate 21 from the epitaxial functional layer 19.

### [Second embodiment]

In the second embodiment, the case where BCB is used as the curable bonding material will be mainly explained. For steps similar to the first embodiment, refer to FIGS. 1 to 7, and for bonded wafer separation, refer to FIG. 9.

First, as shown in FIG. 1, epitaxial growth is performed on a starting substrate 10 to form each layer. This produces an epitaxial functional layer. More specifically, each layer can be epitaxially grown as follows. As shown in FIG. 1, after preparing a first conductivity type GaAs starting substrate 10, a first conductivity type GaAs buffer layer 11 is laminated, and then a first conductivity type GaₓIn₁₋ₓP (0.4≤x≤0.6) first etch stop layer 12, for example 0.3 µm, a first conductivity type GaAs second etch stop layer 13, for example 0.3 µm, a first conductivity type (Al_{y}Ga_{1-y})ₓIn₁₋ₓP (0.4≤x≤0.6, 0<y≤1) first cladding layer 14, for example 1.0 µm, a non-doped (Al_{y}Ga_{1-y})ₓIn₁₋ₓP (0.4≤x≤0.6, 0 ≤y≤0.6) active layer 15, a second conductivity type (Al_{y}Ga_{1-y})ₓIn₁₋ₓP (0.4≤x≤0.6, 0<y≤1) second cladding layer 16, for example 1.0 um, a second conductivity type GaInP intermediate layer 17, for example 0.1 um, and a second conductivity type GaP window layer 18, for example 4 um can be grown sequentially. In this way, an epitaxial wafer 100 having a light emitting device structure as the epitaxial functional layer 19 is prepared. Here, the portion from the AlGaInP first cladding layer 14 to the AlGaInP second cladding layer 16 is referred to as a DH structure (double heterostructure portion) portion.

Next, as shown in FIG. 2, the epitaxial wafer 100 and a foreign substrate 21 are bonded using a curable bonding material 22. More specifically, the bonding can be performed as follows. As shown in FIG. 2, benzocyclobutene (BCB) is spin-coated on an epitaxial wafer 100 as a curable bonding material (thermocurable bonding member) 22, and stacked facing a sapphire wafer as a foreign substrate 21, by thermocompression bonding, the epitaxial wafer 100 and the sapphire wafer, which is the foreign substrate 21, are bonded via BCB, which is the curable bonding material 22. In this way, the epitaxial wafer bonded substrate 200 is produced. When applying BCB by spin coating, the designed film thickness can be, for example, about 1.0 µm.

Note that the method is not limited to spin coating the curable bonding material 22 directly on the epitaxial wafer 100, and the similar effect can be obtained even if spin coating is performed after laminating one or more transparent films on the epitaxial wafer 100, needless to say. The transparent film may have a structure including one or more layers of an insulating film such as SiO₂ or SiNₓ, or a transparent conductive film such as indium oxide, tin oxide, or ITO (indium tin oxide).

Furthermore, the material of the foreign substrate 21 is not limited to sapphire, and any material can be selected as long as it ensures flatness and has a low absorption rate of laser light. In addition to sapphire, SiC, synthetic quartz, quartz (natural quartz), glass, LiTaO₃, LiNbO₃, etc. can be selected.

Further, the curable bonding material 22 is not limited to BCB, and any material can be selected as long as it has curability. In addition to BCB, epoxy resin, SOG (spin-on-glass), PI (Polyimide), etc. may be used.

Next, as shown in FIG. 3, the starting substrate 10 is removed, leaving the epitaxial functional layer 19 on the foreign substrate 21. More specifically, the removal can be performed as follows. As shown in FIG. 3, the GaAs starting substrate 10 and the GaAs buffer layer 11 are removed by wet etching using a selective etching solution such as ammonia peroxide (a mixture of aqueous ammonia and hydrogen peroxide), and the GaInP first etch stop layer 12 is exposed. Next, the etchant is switched to hydrochloric acid type to selectively remove the GaInP first etch stop layer 12 and expose the GaAs second etch stop layer 13. Next, the etchant is switched to a sulfuric acid hydrogen peroxide type to selectively remove the GaAs second etch stop layer 13 and expose the first cladding layer 14. By performing the above processing, a bonded substrate 300 that holds the epitaxial functional layer 19 (more specifically, the DH layer (from the AlGaInP first cladding layer 14 to the AlGaInP second cladding layer 16) and the window layer 18) is manufactured.

In addition, here, as the thickness of the curable bonding material 22, BCB thickness of 1.0 um is illustrated, but it is not limited to this thickness and similar effect of this can be obtained when it may be thinner or thicker than this thickness. However, since the BCB is formed by spin coating, if it is too thin, the area yield after the bonding process tends to decrease. In order to maintain an area yield of 90% or more after bonding, it is preferable to design the adhesive layer thickness to be 0.05 um or more. Moreover, if it is sufficient to maintain a bonding area yield of 70% or more, it is sufficient to design BCB with a thickness of 0.01 um or more. However, from the viewpoint of economic rationality, it is preferable to set the film thickness to 10 um or less.

Next, as shown in FIG. 4, a first electrode 41 is formed in a partial region of the first conductivity type AlGaInP first cladding layer 14. The first electrode 41 is preferably made of a highly reflective metal, and may be made of an Au-based electrode. For the first electrode 41, for example, AuBe-based metal can be used as the metal in contact with the AlGaInP first cladding layer 14.

Next, as shown in FIG. 5, after the first electrode 41 is formed, a part of the first conductivity type AlGaInP first cladding layer 14 other than the region where the first electrode 41 is formed is cut out by a method such as dry etching, the second conductivity type GaP window layer 18 is exposed in the notch.

Although FIG. 5 illustrates the case where only the semiconductor layer portion is cut out, the cutout is not limited to the case where only the semiconductor layer portion is cut out, and cutting may be performed up to the curable bonding material 22 (BCB), or it is also possible to cut out up the foreign substrate 21 portion.

Next, as shown in FIG. 6, the side surfaces are covered with a passivation (PSV) film 65. Furthermore, a bonded substrate having a device structure portion in which a second electrode 61 is formed in the exposed region is manufactured. It is preferable that the second electrode 61 uses a highly reflective metal. Specifically, Au-based materials can be used, and AuSi-based materials are preferred. Note that, as described above, the PSV film 65 may be formed before the second electrode 61 is formed, or the PSV film 65 may be formed after the second electrode 61 is formed. Further, the PSV film 65 itself does not necessarily have to be formed. After forming the first and second electrodes, RTA heat treatment is performed at 400 °C for 5 minutes, for example, in order to obtain ohmic contact.

In this way, a bonded wafer 600 in which the device structure portion having two or more electrodes (the first electrode 41 and the second electrode 61) with different polarities on one surface of the epitaxial functional layer 19 is bonded to the foreign substrate 21 with the curable bonding material 22 is manufactured.

The present invention is a method for separating a bonded wafer 600, in which a support made of a foreign substrate 21 is separated from the bonded wafer 600, by irradiating the bonded wafer 600 with a laser beam, the curable bonding material 22 and/or at least a portion of the surface of the device structure portion that comes into contact with the curable bonding material 22 (i.e., the surface of the window layer 18 in the case of FIG. 6) absorb(s) the laser beam to decompose the curable bonding material 22 and/or the surface of the device structure portion, and thus the device structure portion and the support are separated. In the second embodiment, an aspect in which the curable bonding material 22 is decomposed will be mainly described.

Specifically, this separation can be performed as follows. First, it is preferable to adhere a temporary support substrate 71 coated with an adhesive 72 to the surface of the epitaxial functional layer 19 on the side opposite to the foreign substrate 21 of the bonded wafer before irradiating the laser beam. Specifically, this adhesion is as follows. For example, as shown in FIG. 7, a temporary support substrate 71 is prepared by coating a layered silicone adhesive 72 on a synthetic quartz wafer as a temporary support substrate 71, and the bonded wafer 600 and temporary support substrate 71 are placed facing each other and pressed down and stuck to the adhesive.

Note that the temporary support substrate 71 is not limited to synthetic quartz, but sapphire, quartz (natural quartz), glass, SiC, LiTaO₃, LiNbO₃, or the like can be used.

Next, as shown in FIG. 9, an excimer laser is irradiated from the side of the foreign substrate (sapphire substrate) 21, and the laser beam passes through the foreign substrate (sapphire substrate) 21 and reaches the curable bonding material (BCB bonding layer) 22 absorbed by the BCB layer 22, and the BCB layer 22 is decomposed (ablated) to create voids, and the foreign substrate 21 is separated from the epitaxial functional layer 19.

As mentioned above, as the curable bonding material 22, mainly thermosetting bonding materials such as silicone resin and BCB are exemplified. The present invention can also be applied to a method for separating a bonded wafer in which using materials having UV curability or room temperature curability may also be used.

### EXAMPLE

The present invention will be described in detail below with reference to Examples and a Comparative Example, but these are not intended to limit the present invention.

### (Example 1)

An epitaxial wafer 100 having a light emitting device structure as an epitaxial functional layer 19, in which an n-type GaₓIn₁₋ₓP (0.4≤x≤0.6) first etch stop layer 12 of 0.3 um, an n-type GaAs second etch stop layer 13 of 0.3 um, an n-type (Al_{y}Ga_{1-y})ₓIn₁₋ₓP (0.4≤x≤0.6, 0<y≤1) first cladding layer 14 of 1.0 um, a non-doped (Al_{y}Ga_{1-y})ₓIn₁₋ₓP (0.4≤x≤0.6, 0≤y≤0.6) active layer 15, a p-type (Al_{y}Ga_{1-y})ₓIn₁₋ₓP (0.4≤x≤0.6, 0<y≤1) second cladding layer 16 of 1.0 um, a p-type GaInP intermediate layer 17 of 0.1 um, and a p-type GaP window layer 18 of 4 um were sequentially grown after an n-type GaAs buffer layer 11 was laminated on an n-type GaAs starting substrate, was prepared. (See Figure 1)

Next, a first bonding layer was formed by spin coating a silicone resin as a thermosetting bonding member 22 on the epitaxial wafer 100, and the sapphire substrate, which was a foreign substrate 21, was stacked facing each other and bonded by thermocompression. An epitaxial wafer bonded substrate (first compound semiconductor bonded substrate) 200 was prepared by bonding a wafer 100 and a sapphire substrate, which is a foreign substrate 21, via a silicone resin, which is a curable bonding material 22. When applying the silicone resin by spin coating, the designed film thickness was 1.0 um. (See Figure 2)

The GaAs starting substrate 10 and the GaAs buffer layer 11 were removed by wet etching using ammonia peroxide, and the GaInP first etch stop layer 12 was exposed. Next, the etchant was switched to a hydrochloric acid type to selectively remove the GaInP first etch stop layer 12 and expose the GaAs second etch stop layer 13. Next, the etchant was switched to a sulfuric acid hydrogen peroxide type to selectively remove the GaAs second etch stop layer 13 and expose the first cladding layer 14. By performing the above processing, a bonded substrate (second compound semiconductor bonded substrate) 300 holding the epitaxial functional layer 19 (more specifically, the DH layer (from the first cladding layer 14 to the second cladding layer 16) and window layer 18) was manufactured. (See Figure 3)

Next, an AuBe-based first electrode 41 was formed on a partial region of the n-type first cladding layer 14. (See Figure 4)

After forming the first electrode, a part of the n-type first cladding layer 14 other than the region where the first electrode 41 was formed was cut out by dry etching, and the p-type GaP window layer 18 was exposed in the cutout portion. (See Figure 5)

Next, a bonded wafer (bonded substrate having a device structure portion) 600 was manufactured, whose side surfaces were covered with a passivation (PSV) film 65 and an AuSi-based second electrode 61 was formed in the exposed region. After forming the first and second electrodes, RTA heat treatment was performed at 400 °C for 5 minutes to obtain ohmic contact. (See Figure 6)

Next, a temporary support substrate 71 was prepared by coating a layered silicone adhesive 72 on a synthetic quartz wafer as a temporary support substrate 71, and the bonded wafer 600 and the temporary support substrate 71 were placed facing each other and pressed to make the adhesive adhere to the temporary support substrate 71. (See Figure 7)

An excimer laser was irradiated from the side of the sapphire substrate, which was the foreign substrate 21, and the laser beam that passes through the sapphire substrate and the silicone bonding layer 72 was absorbed by the p-type GaP window layer 18 and decomposed (ablated), thereby forming the foreign substrate 21 separated from the epitaxial functional layer 19. (See Figure 8)

### (Example 2)

An epitaxial wafer 100 having a light emitting device structure as an epitaxial functional layer 19, in which an n-type GaₓIn₁₋ₓP (0.4≤x≤0.6) first etch stop layer 12 of 0.3 um, an n-type GaAs second etch stop layer 13 of 0.3 um, an n-type (Al_{y}Ga_{1-y})ₓIn₁₋ₓP (0.4≤x≤0.6, 0<y≤1) first cladding layer 14 of 1.0 um, a non-doped (Al_{y}Ga_{1-y})ₓIn₁₋ₓP (0.4≤x≤0.6, 0≤y≤0.6) active layer 15, a p-type (Al_{y}Ga_{1-y})ₓIn₁₋ₓP (0.4≤x≤0.6, 0<y≤1) second cladding layer 16 of 1.0 um, a p-type GaInP intermediate layer 17 of 0.1 um, and a p-type GaP window layer 18 of 4 um were sequentially grown after an n-type GaAs buffer layer 11 was laminated on an n-type GaAs starting substrate, was prepared. (See Figure 1)

A first bonding layer was formed by spin-coating benzocyclobutene (BCB) as a thermosetting bonding member 22 on the epitaxial wafer 100, and the sapphire substrate, which was a foreign substrate 21, was stacked facing each other and bonded by thermocompression. An epitaxial wafer bonded substrate (first compound semiconductor bonded substrate) 200 was prepared by bonding an epitaxial wafer 100 and a sapphire substrate, which was a foreign substrate 21, via a BCB. When applying BCB by spin coating, the designed film thickness was 1.0 um. (See Figure 2)

Next, the GaAs starting substrate 10 and the GaAs buffer layer 11 were removed by wet etching using a selective etching solution such as ammonia peroxide, and the GaInP first etch stop layer 12 was exposed. Next, the etchant was switched to a hydrochloric acid type to selectively remove the GaInP first etch stop layer 12 and expose the GaAs second etch stop layer 13. Next, the etchant was switched to a sulfuric acid hydrogen peroxide type to selectively remove the GaAs second etch stop layer 13 and expose the first cladding layer 14. By performing the above processing, the bonded substrate (second compound semiconductor bonded substrate) 300 holding the epitaxial functional layer 19 (more specifically, the DH layer (from first cladding layer 14 to second cladding layer 16) and window layer 18) was manufactured. (See Figure 3)

Next, an AuBe-based first electrode 41 was formed on a partial region of the n-type first cladding layer 14. (See Figure 4)

After forming the first electrode, a part of the n-type first cladding layer 14 other than the region where the first electrode 41 was formed was cut out by dry etching, and the p-type GaP window layer 18 was exposed in the cutout portion. (See Figure 5)

A bonded wafer (bonded substrate having a device structure portion) 600 was manufactured, whose side surfaces were covered with a passivation (PSV) film 65 and an AuSi-based second electrode 61 formed in the exposed region.

After forming the first and second electrodes, RTA heat treatment was performed at 400 °C for 5 minutes to obtain ohmic contact. (See Figure 6)

Next, a temporary support substrate 71 was prepared by coating a layered silicone adhesive 72 on a synthetic quartz wafer as a temporary support substrate 71, and the bonded wafer 600 and the temporary support substrate 71 were placed facing each other and pressed to make the adhesive adhere to the temporary support substrate 71. (See Figure 7)

An excimer laser was irradiated from the sapphire substrate side, which was the foreign substrate 21, and the laser beam passed through the sapphire substrate and reached the BCB bonding layer 72. The BCB layer absorbed the laser beam, and the BCB layer decomposes (ablates) to create voids. The sapphire substrate, which was the foreign substrate 21, was separated from the epitaxial functional layer. (See Figure 9)

### (Comparative example)

An epitaxial wafer having a light emitting device structure as an epitaxial functional layer, in which an n-type GaₓIn₁₋ₓP (0.4≤x≤0.6) first etch stop layer of 0.3 um, an n-type GaAs second etch stop layer of 0.3 um, an n-type (Al_{y}Ga_{1-y})ₓIn₁₋ₓP (0.4≤x≤0.6, 0<y≤1) first cladding layer of 1.0 um, a non-doped (Al_{y}Ga1_{-y})ₓIn₁₋ₓP (0.4≤x≤0.6, 0≤y≤0.6) active layer, a p-type (Al_{y}Ga_{1-y})ₓIn₁₋ₓP (0.4≤x≤0.6, 0<y≤1) second cladding layer of 1.0 um, a p-type GaInP intermediate layer of 0.1 um, and a p-type GaP window layer of 4 um were sequentially grown after an n-type GaAs buffer layer 11 was laminated on an n-type GaAs starting substrate, was prepared.

Next, benzocyclobutene (BCB) was spin-coated on the epitaxial wafer as a thermosetting bonding member, stacked facing a silicon wafer, and bonded by thermocompression to bond the epitaxial wafer and the silicon wafer via the BCB. An EPW bonded substrate was manufactured. When applying BCB by spin coating, the designed film thickness was 1.0 µm.

Removing the GaAs starting substrate by wet etching to expose the first etch stop layer, switching the etchant and removing the second etch stop layer to expose the first cladding layer, a bonded substrate which held the DH layer and the window layer was manufactured.

Next, an AuBe-based first electrode was formed on a partial region of the n-type first cladding layer.

After forming the first electrode, a part of the n-type first cladding layer other than the region where the first electrode was formed was cut out by dry etching, and the p-type GaP window layer was exposed in the cutout portion.

The sides were covered with a passivation (PSV) film. A bonded wafer (bonded substrate having a device structure portion) in which an AuSi-based second electrode was formed in the exposed region was manufactured. After forming the first and second electrodes, RTA heat treatment was performed at 400 °C for 5 minutes to obtain ohmic contact.

Next, a temporary support substrate was prepared by coating a layered silicone adhesive on a silicon wafer, and the bonded substrate having the device structure portion and the temporary support substrate were placed facing each other and pressed to adhere to the adhesive.

A thin film was processed on the silicon wafer (foreign substrate) side by surface grinding and other treatments. After the thickness of the silicon wafer (foreign substrate) reached a film thickness of 150 um or less, the silicon wafer (foreign substrate) was removed by immersing it in a fluoric acid nitric acid based etching solution. After removing the silicon wafer (foreign substrate), BCB was removed by ashing or dry etching.

Table 1 shows the device portion survival rates after removal of foreign substrates in Example 1, Example 2, and Comparative Example. In Examples 1 and 2, the stress applied to the device during the separation process is small and the device portion survival rate is good, whereas in the comparative example, the mechanical stress applied to the device portion during machining of a foreign of substrate is large and the device portion is damaged after processing, resulting in a decrease in the survival rate of the device portion.

**(Table 1)**

| | Survival rate |
|---|---|
| Example 1 | 94 - 99 % |
| Example 2 | 95 - 99 % |
| Comparative Example | 62 - 84 % |

The present invention is particularly effective when the starting substrate for epitaxial growth is an opaque substrate. Since such opaque substrates do not allow the laser to pass through, or only pass the laser to an insufficient extent for ablation to occur, it is difficult to separate the device structures by irradiating the starting substrate for epitaxial growth with a laser (also called laser lift-off). Therefore, it is effective when the starting substrate for epitaxial growth is a gallium arsenide substrate or when the device structure portion is a red LED. This red LED may be a micro LED or a mini LED.

In addition, it is preferable that the various substrates (starting substrate for epitaxial growth, support, foreign substrate, temporary support substrate) in the present invention have a disk shape from the viewpoint of cost and ease of application to various devices. The effects of the present invention can be achieved even with other shapes such as an elliptical shape, a columnar shape or a polygonal prism shape such as a square prism.

Furthermore, in FIG. 6 and the like, one device structure portion is depicted, but a plurality of device structure portions may be bonded to the support, and the plurality of device structure portions may be arranged in a shape of matrix.

Further, as the shape of the device structure portion when observed in a direction perpendicular to the main surface of the support, a circular shape, an elliptical shape, polygonal shapes such as a quadrangular shape can be mentioned. Among these, a rectangular shape is preferable because the number of device structure portions that can be manufactured at one time can be increased. Here, circular, elliptical, square, and polygonal shapes do not mean strict circular, elliptical, square, and polygonal shapes, but the meaning includes dents and bulges in straight and curved parts, and chamfers at corners.

Further, the thickness of the cured material layer for bonding the device structure portion may be any thickness that can withstand the steps up to separate the device structure portion from the support. In other words, since the support will eventually be separated, it is not necessary to have bonding reliability over several years, and the support may be relatively thin. This is advantageous when performing laser lift-off. Specifically, it is preferably 0.1 to 1.0 um, more preferably 0.4 to 0.6 um, depending on the material contained in the curable bonding material and bonding performance.

The embodiments of the present invention have been described in detail above, but the present invention can be expressed from different viewpoints, it becomes as shown in (1) to (15), (U1) to (U89), and (X1) to (X4) below.
(1) A bonded wafer in which a device structure portion is bonded to a support via a cured layer of a curable bonding material, and the bonded wafer is used for separating the device structure portion by laser beam irradiation.
(2) The bonded wafer according to (1), wherein the device structure portion is a red LED chip.
(3) The bonded wafer according to (1), wherein the device structure portion includes an AlGaInP-based material.
(4) The bonded wafer according to (1), wherein the thickness of the cured material layer is 0.1 to 1.0 um.
(5) The bonded wafer according to (2), wherein the thickness of the cured material layer is 0.4 to 0.6 um.
(6) The bonded wafer according to (1), wherein the device structure portion has an epitaxial functional layer from which a starting substrate for epitaxial growth has been removed.
(7) The bonded wafer according to (1), wherein the curable bonding material includes at least one selected from the group consisting of benzocyclobutene, polyimide, fluororesin, epoxy resin, and silicone resin.
(8) The bonded wafer according to (1), wherein the support includes at least one selected from the group consisting of a sapphire substrate, a SiC substrate, a synthetic quartz substrate, a quartz substrate, a glass substrate, a LiTaO₃ substrate, and a LiNbO₃ substrate.
(9) The bonded wafer according to (1), wherein the device structure portion is a red LED chip including an AlGaInP-based material,
   the thickness of the cured material layer is 0.1 to 1.0 um,
   the device structure portion includes an epitaxial functional layer from which a starting substrate for epitaxial growth has been removed,
   the curable bonding material includes at least one selected from the group consisting of benzocyclobutene, polyimide, fluororesin, epoxy resin, and silicone resin, and the support includes at least one selected from the group consisting of a sapphire substrate, a SiC substrate, a synthetic quartz substrate, a quartz substrate, a glass substrate, a LiTaO₃ substrate, and a LiNbO₃ substrate.
(10) The bonded wafer according to (1), wherein the device structure portion is a red LED chip including an AlGaInP-based material:
   the thickness of the cured material layer is 0.4 to 0.6 um,
   the device structure portion includes an epitaxial functional layer from which a starting substrate for epitaxial growth has been removed,
   the curable bonding material includes benzocyclobutene, and the support includes a sapphire substrate.
(11) A method for separating a bonded wafer in which a support is separated from a bonded wafer in which a device structure portion is bonded to a support via a cured layer of a curable bonding material,
   wherein the device structure portion and the support are separated by irradiating a laser beam from the support side of the bonded wafer.
(12) A method for manufacturing a separated device structure portion, in which a support is separated from a bonded wafer in which a device structure portion is bonded to a support via a cured layer of a curable bonding material,
   wherein the device structure portion and the support are separated by irradiating a laser beam from the support side of the bonded wafer.
(13) A bonded body in which a device structure portion is bonded to a support via a cured layer of a curable bonding material, and the bonded body is used for separating the device structure portion by laser beam irradiation.
(14) A method for separating a bonded body in which a device structure portion is bonded to a support via a cured material layer of a curable bonding material,
   wherein the device structure portion and the support body are separated by irradiating a laser beam from the support side of the bonded body.
(15) A method for manufacturing a separated device structure portion, in which the support is separated from a bonded body in which the device structure portion is bonded to the support via a cured material layer of a curable bonding material,
   wherein the device structure portion and the support are separated by irradiating a laser beam from the support side of the bonded body.

(U1) A bonded wafer separating system for separating a support from a bonded wafer which comprises a device structure portion having two or more electrodes with different polarities on one side of an epitaxial functional layer, and the device structure portion being bonded to a support made of a foreign substrate using a curable bonding material,
   wherein it has a mechanism that, by irradiating the bonded wafer with a laser beam oscillated from a laser oscillator, the curable bonding material and/or at least a portion of the surface of the device structure portion that comes into contact with the curable bonding material absorb(s) the laser beam to decompose the curable bonding material and/or the surface of the device structure portion, and thus the device structure portion and the support are separated.
(U2) The bonded wafer separating system according to (U1), wherein the epitaxial functional layer has a light emitting device structure.
(U3) The bonded wafer separating system according to (U1) or (U2), wherein the epitaxial functional layer includes an AlGaInP-based material.
(U4) The bonded wafer separating system according to (U1) or (U2), wherein the curable bonding material has any one of thermosetting properties, UV curability, and room temperature curability.
(U5) The bonded wafer separating system according to (U1) or (U2), wherein the curable bonding material includes any one of benzocyclobutene, polyimide, fluororesin, epoxy resin, and silicone resin.
(U6) The bonded wafer separating system according to (U1) or (U2), wherein the epitaxial functional layer has a starting substrate for epitaxial growth being removed.
(U7) The bonded wafer separating system according to (U1) or (U2), wherein the foreign substrate is made of any one of sapphire, SiC, synthetic quartz, quartz, glass, LiTaO₃, and LiNbO₃.
(U8) The bonded wafer separating system according to (U1) or (U2), wherein the laser beam is an excimer laser.
(U9) The bonded wafer separating system according to (U1) or (U2), wherein a temporary support substrate coated with an adhesive is adhered to a surface of the epitaxial functional layer of the bonded wafer opposite to the foreign substrate before the laser beam irradiation.
(U10) The bonded wafer separating system according to (U9), wherein the adhesive is silicone.
(U11) The bonded wafer separating system according to (U1), wherein the temporary support substrate is made of any one of sapphire, SiC, synthetic quartz, quartz, glass, LiTaO₃, and LiNbO₃.
(U12) A bonded wafer in which a rectangular device structure portion is bonded to a support via a cured layer of a curable bonding material, and which is used for separation of the device structure portion by laser beam irradiation.
(U13) The bonded wafer according to (U12), wherein the device structure portion is a red LED chip.
(U14) The bonded wafer according to (U12), wherein the device structure portion includes an AlGaInP-based material.
(U15) The bonded wafer according to (U12), wherein the thickness of the cured material layer is 0.1 to 1.0 um.
(U16) The bonded wafer according to (U13), wherein the thickness of the cured material layer is 0.1 to 1.0 um.
(U17) The bonded wafer according to (U12), wherein the thickness of the cured material layer is 0.4 to 0.6 um.
(U18) The bonded wafer according to (U13), wherein the thickness of the cured material layer is 0.4 to 0.6 um.
(U19) The bonded wafer according to (U12), wherein the device structure portion has an epitaxial functional layer from which the starting substrate for epitaxial growth has been removed.
(U20) The bonded wafer according to (U12), wherein the curable bonding material includes at least one selected from the group consisting of benzocyclobutene, polyimide, fluororesin, epoxy resin, and silicone resin.
(U21) The bonded wafer according to (U12), wherein the support has at least one selected from the group consisting of a sapphire substrate, a SiC substrate, a synthetic quartz substrate, a quartz substrate, a glass substrate, a LiTaO₃ substrate, and a LiNbO₃ substrate.
(U22) The bonded wafer according to (U12), wherein the device structure portion is a red LED chip including an AlGaInP-based material,
   the thickness of the cured material layer is 0.1 to 1.0 um,
   the device structure portion includes an epitaxial functional layer from which a starting substrate for epitaxial growth has been removed,
   the curable bonding material includes at least one selected from the group consisting of benzocyclobutene, polyimide, fluororesin, epoxy resin, and silicone resin,
   and the support includes at least one selected from the group consisting of a sapphire substrate, a SiC substrate, a synthetic quartz substrate, a quartz substrate, a glass substrate, a LiTaO₃ substrate, and a LiNbO₃ substrate.
(U23) The bonded wafer according to (U12), wherein the device structure portion is a red LED chip including an AlGaInP-based material,
   the thickness of the cured material layer is 0.4 to 0.6 um,
   the device structure portion includes an epitaxial functional layer from which a starting substrate for epitaxial growth has been removed,
   the curable bonding material contains benzocyclobutene, and
   and the support includes a sapphire substrate.
(U24) The bonded wafer according to (U12), wherein a plurality of the device structure portions are bonded on the support, and the plurality of device structure portions are arranged in a matrix.
(U25) A bonded wafer separating system for separating a support from a bonded wafer in which a device structure portion is bonded to a support via a cured layer of a curable bonding material,
   the bonded wafer separating system comprises a mechanism for separating the device structure portion and the support by irradiating a laser beam oscillated from a laser oscillator from the support side of the bonded wafer.
(U26) The bonded wafer separating system according to (U25), wherein the device structure portion is a red LED chip.
(U27) The bonded wafer separating system according to (U25), wherein the device structure portion includes an AlGaInP-based material.
(U28) The bonded wafer separating system according to (U25), wherein the thickness of the cured material layer is 0.1 to 1.0 um.
(U29) The bonded wafer separating system according to (U26), wherein the thickness of the cured material layer is 0.1 to 1.0 um.
(U30) The bonded wafer separating system according to (U25), wherein the thickness of the cured material layer is 0.4 to 0.6 um.
(U31) The bonded wafer separating system according to (U26), wherein the thickness of the cured material layer is 0.4 to 0.6 um.
(U32) The bonded wafer separating system according to (U25), wherein the device structure portion has an epitaxial functional layer from which the starting substrate for epitaxial growth has been removed.
(U33) The bonded wafer separating system according to (U25), wherein the curable bonding material includes at least one selected from the group consisting of benzocyclobutene, polyimide, fluororesin, epoxy resin, and silicone resin.
(U34) The bonded wafer separating system according to (U25), wherein the support has at least one selected from the group consisting of a sapphire substrate, a SiC substrate, a synthetic quartz substrate, a quartz substrate, a glass substrate, a LiTaO₃ substrate, and a LiNbO₃ substrate.
(U35) The bonded wafer separating system according to (U25), wherein the device structure portion is a red LED chip including an AlGaInP-based material,
   the thickness of the cured material layer is 0.1 to 1.0 um,
   the device structure portion includes an epitaxial functional layer from which a starting substrate for epitaxial growth has been removed,
   the curable bonding material includes at least one selected from the group consisting of benzocyclobutene, polyimide, fluororesin, epoxy resin, and silicone resin,
   and the support includes at least one selected from the group consisting of a sapphire substrate, a SiC substrate, a synthetic quartz substrate, a quartz substrate, a glass substrate, a LiTaO₃ substrate, and a LiNbO₃ substrate.
(U36) The bonded wafer separating system according to (U25), wherein the device structure portion is a red LED chip including an AlGaInP-based material,
   the thickness of the cured material layer is 0.4 to 0.6 um,
   the device structure portion includes an epitaxial functional layer from which a starting substrate for epitaxial growth has been removed,
   the curable bonding material includes benzocyclobutene,
   and the support includes a sapphire substrate.
(U37) The bonded wafer separating system according to (U25), wherein a plurality of the device structure portions are bonded on the support, and the plurality of device structure portions are arranged in a matrix.
(U38) A system for manufacturing a separated device structure portion, in which the support is separated from a bonded wafer in which the device structure portion is bonded to the support via a cured layer of a curable bonding material,
   wherein a mechanism for separating the device structure portion and the support by irradiating a laser beam oscillated from a laser oscillator from the support side of the bonded wafer is provided.
(U39) The system for manufacturing a separated device structure portion according to (U38), wherein the device structure portion is a red LED chip.
(U40) The system for manufacturing a separated device structure portion according to (U38), wherein the device structure portion includes an AlGaInP-based material.
(U41) The system for manufacturing a separated device structure portion according to (U38), wherein the thickness of the cured material layer is 0.1 to 1.0 um.
(U42) The system for manufacturing a separated device structure portion according to (U39), wherein the thickness of the cured material layer is 0.1 to 1.0 um.
(U43) The system for manufacturing a separated device structure portion according to (U38), wherein the thickness of the cured material layer is 0.4 to 0.6 um.
(U44) The system for manufacturing a separated device structure portion according to (U39), wherein the thickness of the cured material layer is 0.4 to 0.6 um.
(U45) The system for manufacturing a separated device structure portion according to (U38), wherein the device structure portion has an epitaxial functional layer from which a starting substrate for epitaxial growth has been removed.
(U46) The system for manufacturing a separated device structure portion according to (U38), wherein the curable bonding material includes at least one selected from the group consisting of benzocyclobutene, polyimide, fluororesin, epoxy resin, and silicone resin.
(U47) The system for manufacturing a separated device structure portion according to (U38), wherein the support includes at least one selected from the group consisting of a sapphire substrate, a SiC substrate, a synthetic quartz substrate, a quartz substrate, a glass substrate, a LiTaO₃ substrate, and a LiNbO₃ substrate.
(U48) The system for manufacturing a separated device structure portion according to (U38), wherein the device structure portion is a red LED chip including an AlGaInP-based material,
   the thickness of the cured material layer is 0.1 to 1.0 um,
   the device structure portion includes an epitaxial functional layer from which a starting substrate for epitaxial growth has been removed,
   the curable bonding material includes at least one selected from the group consisting of benzocyclobutene, polyimide, fluororesin, epoxy resin, and silicone resin, and the support includes at least one selected from the group consisting of a sapphire substrate, a SiC substrate, a synthetic quartz substrate, a quartz substrate, a glass substrate, a LiTaO₃ substrate, and a LiNbO₃ substrate.
(U49) The system for manufacturing a separated device structure portion according to (U38), wherein the device structure portion is a red LED chip including an AlGaInP-based material,
   the thickness of the cured material layer is 0.4 to 0.6 um,
   the device structure portion includes an epitaxial functional layer from which a starting substrate for epitaxial growth has been removed,
   the curable bonding material includes benzocyclobutene,
   and the support includes a sapphire substrate.
(U50) The system for manufacturing separated device structures portion according to (U38), wherein a plurality of the device structures portions are bonded on the support, and the plurality of device structure portions are arranged in a matrix.
(U51) A separated bonded body in which a square device structure portion is bonded to a support via a cured layer of a curable bonding material, and is used for separating the device structure portion by laser beam irradiation.
(U52) The separated bonded body according to (U51), wherein the device structure portion is a red LED chip.
(U53) The separated bonded body according to (U51), wherein the device structure portion includes an AlGaInP-based material.
(U54) The separated bonded body according to (U51), wherein the thickness of the cured material layer is 0.1 to 1.0 um.
(U55) The separated bonded body according to (U52), wherein the thickness of the cured material layer is 0.1 to 1.0 um.
(U56) The separated bonded body according to (U51), wherein the thickness of the cured material layer is 0.4 to 0.6 um.
(U57) The separated bonded body according to (U52), wherein the thickness of the cured material layer is 0.4 to 0.6 um.
(U58) The separated bonded body according to (U51), wherein the device structure portion has an epitaxial functional layer from which the starting substrate for epitaxial growth has been removed.
(U59) The separated bonded body according to (U51), wherein the curable bonding material includes at least one selected from the group consisting of benzocyclobutene, polyimide, fluororesin, epoxy resin, and silicone resin.
(U60) The separated bonded body according to (U51), wherein the support includes at least one selected from the group consisting of a sapphire substrate, a SiC substrate, a synthetic quartz substrate, a quartz substrate, a glass substrate, a LiTaO₃ substrate, and a LiNbO₃ substrate.
(U61) The separated bonded body according to (U51), wherein the device structure portion is a red LED chip including an AlGaInP-based material,
   the thickness of the cured material layer is 0.1 to 1.0 um,
   the device structure portion includes an epitaxial functional layer from which a starting substrate for epitaxial growth has been removed,
   the curable bonding material includes at least one selected from the group consisting of benzocyclobutene, polyimide, fluororesin, epoxy resin, and silicone resin,
   and the support includes at least one selected from the group consisting of a sapphire substrate, a SiC substrate, a synthetic quartz substrate, a quartz substrate, a glass substrate, a LiTaO₃ substrate, and a LiNbO₃ substrate.
(U62) The separated bonded body according to (U51), wherein the device structure portion is a red LED chip including an AlGaInP-based material,
   the thickness of the cured material layer is 0.4 to 0.6 um,
   the device structure portion includes an epitaxial functional layer from which a starting substrate for epitaxial growth has been removed,
   the curable bonding material includes benzocyclobutene,
   and the support body includes a sapphire substrate.
(U63) The separated bonded body according to (U51), wherein a plurality of the device structure portions are bonded on the support, and the plurality of device structure portions are arranged in a matrix.
(U64) A bonded body separating system for separating a support from a bonded body in which a device structure portion is bonded to a support via a cured material layer of a curable bonding material,
   wherein the bonded body separating system comprising a mechanism for separating the device structure portion and the support body by irradiating a laser beam oscillated from a laser oscillator from the support body side of the bonded body.
(U65) The bonded body separating system according to (U64), wherein the device structure portion is a red LED chip.
(U66) The bonded body separating system according to (U64), wherein the device structure portion includes an AlGaInP-based material.
(U67) The bonded body separating system according to (U64), wherein the thickness of the cured material layer is 0.1 to 1.0 um.
(U68) The bonded body separating system according to (U65), wherein the thickness of the cured material layer is 0.1 to 1.0 um.
(U69) The bonded body separating system according to (U64), wherein the thickness of the cured material layer is 0.4 to 0.6 µm.
(U70) The bonded body separating system according to (U65), wherein the thickness of the cured material layer is 0.4 to 0.6 um.
(U71) The bonded body separating system according to (U64), wherein the device structure portion has an epitaxial functional layer from which the starting substrate for epitaxial growth has been removed.
(U72) The bonded body separating system according to (U64), wherein the curable bonding material includes at least one selected from the group consisting of benzocyclobutene, polyimide, fluororesin, epoxy resin, and silicone resin.
(U73) The bonded body separating system according to (U64), wherein the support includes at least one selected from the group consisting of a sapphire substrate, a SiC substrate, a synthetic quartz substrate, a quartz substrate, a glass substrate, a LiTaO₃ substrate, and a LiNbO₃ substrate.
(U74) The bonded body separating system according to (U64), wherein the device structure portion is a red LED chip including an AlGaInP-based material,
   the thickness of the cured material layer is 0.1 to 1.0 um,
   the device structure portion includes an epitaxial functional layer from which a starting substrate for epitaxial growth has been removed,
   the curable bonding material includes at least one selected from the group consisting of benzocyclobutene, polyimide, fluororesin, epoxy resin, and silicone resin,
   and the support includes at least one selected from the group consisting of a sapphire substrate, a SiC substrate, a synthetic quartz substrate, a quartz substrate, a glass substrate, a LiTaO₃ substrate, and a LiNbO₃ substrate.
(U75) The bonded body separating system according to (U64), wherein the device structure portion is a red LED chip including an AlGaInP-based material,
   the thickness of the cured material layer is 0.4 to 0.6 um,
   the device structure portion includes an epitaxial functional layer from which a starting substrate for epitaxial growth has been removed,
   the curable bonding material includes benzocyclobutene,
   and the support includes a sapphire substrate.
(U76) The bonded body separating system according to (U64), wherein a plurality of the device structure portions are bonded on the support, and the plurality of device structure portions are arranged in a matrix.
(U77) A system for manufacturing a separated device structure portion, in which the support is separated from a bonded body in which the device structure portion is bonded to the support via a cured material layer of a curable bonding material,
   wherein the system has a mechanism for separating the device structure portion and the support by irradiating a laser beam oscillated from a laser oscillator from the support side of the bonded body.
(U78) The system for manufacturing a separated device structure portion according to (U77), wherein the device structure portion is a red LED chip.
(U79) The system for manufacturing a separated device structure portion according to (U77), wherein the device structure portion includes an AlGaInP-based material.
(U80) The system for manufacturing a separated device structure portion according to (U77), wherein the thickness of the cured material layer is 0.1 to 1.0 um.
(U81) The system for manufacturing a separated device structure portion according to (U78), wherein the thickness of the cured material layer is 0.1 to 1.0 um.
(U82) The system for manufacturing a separated device structure portion according to (U77), wherein the thickness of the cured material layer is 0.4 to 0.6 um.
(U83) The system for manufacturing a separated device structure portion according to (U78), wherein the thickness of the cured material layer is 0.4 to 0.6 µm.
(U84) The system for manufacturing a separated device structure portion according to (U77), wherein the device structure portion has an epitaxial functional layer from which the starting substrate for epitaxial growth has been removed.
(U85) The system for manufacturing a separated device structure portion according to (U77), wherein the curable bonding material includes at least one selected from the group consisting of benzocyclobutene, polyimide, fluororesin, epoxy resin, and silicone resin.
(U86) The system for manufacturing a separated device structure portion according to (U77), wherein the support includes at least one selected from the group consisting of a sapphire substrate, a SiC substrate, a synthetic quartz substrate, a quartz substrate, a glass substrate, a LiTaO₃ substrate, and a LiNbO₃ substrate.
(U87) The system for manufacturing a separated device structure portion according to (U77), wherein the device structure portion is a red LED chip including an AlGaInP-based material,
   the thickness of the cured material layer is 0.1 to 1.0 um,
   the device structure portion includes an epitaxial functional layer from which a starting substrate for epitaxial growth has been removed,
   the curable bonding material includes at least one selected from the group consisting of benzocyclobutene, polyimide, fluororesin, epoxy resin, and silicone resin,
   and the support includes at least one selected from the group consisting of a sapphire substrate, a SiC substrate, a synthetic quartz substrate, a quartz substrate, a glass substrate, a LiTaO₃ substrate, and a LiNbO₃ substrate.
(U88) The system for manufacturing a separated device structure portion according to (U77), wherein the device structure portion is a red LED chip including an AlGaInP-based material,
   the thickness of the cured material layer is 0.4 to 0.6 um,
   the device structure portion includes an epitaxial functional layer from which a starting substrate for epitaxial growth has been removed,
   the curable bonding material includes benzocyclobutene,
   and the support includes a sapphire substrate.
(U89) The system for manufacturing a separated device structure portion according to (U77), wherein a plurality of the device structure portions are bonded on the support, and the plurality of device structure portions are arranged in a matrix.
(X1) Application to separation of a bonded wafer in which a device structure portion is bonded to a support by irradiation with laser beam,
   wherein, the device structure portion is bonded to the support body via a cured material layer of a curable bonding material.
(X2) Application to manufacture of a bonded wafer in which a device structure portion is bonded to a support used for separating the device structure portion by laser light irradiation,
   wherein, the device structure portion is bonded to the support body via a cured material layer of a curable bonding material.
(X3) Application to separation of a bonded wafer in which a device structure portion is bonded to a support by irradiation with laser light,
   wherein, the device structure portion is bonded to the support body via a cured material layer of a curable bonding material.
(X4) Application to manufacture of a bonded wafer in which a device structure portion is bonded to a support used for separating the device structure portion by laser light irradiation,
   wherein, the device structure portion is bonded to the support body via a cured material layer of a curable bonding material.

Each component in the many embodiments described above is subdivided, and each of the subdivided components is used alone or in combination to create these (1) to (15), (U1) to (U88), and (X1) to (X4) can be introduced. For example, typical examples include materials, properties, dimensions, shapes and formation methods of various substrates and various layers, types of laser beams, separating methods, and structures of device structure portions.

Note that the present invention is not limited to the above embodiments. The above-described embodiments are just examples, and any examples that substantially have the same configuration and demonstrate the same functions and effects as those in the technical concept disclosed in the claims of the present invention are included in the technical scope of the present invention.

## Claims

1. A method for separating a bonded wafer, the method comprises separating a support from a bonded wafer which comprises a device structure portion having two or more electrodes with different polarities on one side of an epitaxial functional layer, and the device structure portion being bonded to a support made of a foreign substrate using a curable bonding material,
wherein, by irradiating the bonded wafer with a laser beam, the curable bonding material and/or at least a portion of the surface of the device structure portion that comes into contact with the curable bonding material absorb(s) the laser beam to decompose the curable bonding material and/or the surface of the device structure portion, and thus the device structure portion and the support are separated.

2. The method for separating a bonded wafer according to claim 1, wherein the epitaxial functional layer has a light emitting device structure.

3. The method for separating a bonded wafer according to claim 1 or 2, wherein the epitaxial functional layer contains an AlGaInP-based material.

4. The method for separating a bonded wafer according to any one of claims 1 to 3, wherein the curable bonding material has curability properties any one of thermosetting properties, UV curability properties, and room temperature curability properties.

5. The method for separating a bonded wafer according to claim 4, wherein the curable bonding material contains any one of benzocyclobutene, polyimide, fluororesin, epoxy resin, and silicone resin.

6. The method for separating a bonded wafer according to any one of claims 1 to 5, wherein the epitaxial functional layer has a starting substrate for epitaxial growth removed from the epitaxial functional layer.

7. The method for separating a bonded wafer according to any one of claims 1 to 6, wherein the foreign substrate is made of any one of sapphire, SiC, synthetic quartz, quartz, glass, LiTaO₃, and LiNbO₃.

8. The method for separating a bonded wafer according to any one of claims 1 to 7, wherein the laser beam is an excimer laser.

9. The method for separating a bonded wafer according to any one of claims 1 to 8, wherein a temporary support substrate coated with an adhesive is adhered to a surface of the epitaxial functional layer of the bonded wafer opposite to the foreign substrate before the laser beam irradiation.

10. The method for separating a bonded wafer according to claim 9, wherein the adhesive is silicone.

11. The method for separating a bonded wafer according to claim 9 or 10, wherein the temporary support substrate is made of any one of sapphire, SiC, synthetic quartz, quartz, glass, LiTaO₃, and LiNbO₃.

12. A bonded wafer in which a device structure portion is bonded to a support via a cured layer of a curable bonding material, wherein the bonded wafer is used for separating the device structure portion by laser beam irradiation.

13. The bonded wafer according to claim 12, wherein the device structure portion is a red LED chip.

14. The bonded wafer according to claim 12, wherein the device structure portion includes an AlGaInP-based material.

15. The bonded wafer according to claim 12, wherein the thickness of the cured material layer is 0.1 to 1.0 um.

16. The bonded wafer according to claim 13, wherein the thickness of the cured material layer is 0.4 to 0.6 um.

17. The bonded wafer according to claim 12, wherein the device structure portion includes an epitaxial functional layer from which a starting substrate for epitaxial growth has been removed.

18. The bonded wafer according to claim 12, wherein the curable bonding material includes at least one selected from a group consisting of benzocyclobutene, polyimide, fluororesin, epoxy resin, and silicone resin.

19. The bonded wafer according to claim 12, wherein the support includes at least one selected from a group consisting of a sapphire substrate, a SiC substrate, a synthetic quartz substrate, a quartz substrate, a glass substrate, a LiTaO₃ substrate, and a LiNbO₃ substrate.

20. The bonded wafer according to claim 12, wherein the device structure portion is a red LED chip containing an AlGaInP-based material,
the thickness of the cured material layer is 0.1 to 1.0 um,
the device structure portion has an epitaxial functional layer from which a starting substrate for epitaxial growth has been removed,
the curable bonding material includes at least one selected from the group consisting of benzocyclobutene, polyimide, fluororesin, epoxy resin, and silicone resin, and
the support has at least one selected from the group consisting of a sapphire substrate, a SiC substrate, a synthetic quartz substrate, a quartz substrate, a glass substrate, a LiTaO₃ substrate, and a LiNbO₃ substrate.

21. The bonded wafer according to claim 12, wherein the device structure portion is a red LED chip containing an AlGaInP-based material,
the thickness of the cured material layer is 0.4 to 0.6 um,
the device structure portion has an epitaxial functional layer from which a starting substrate for epitaxial growth has been removed,
the curable bonding material contains benzocyclobutene, and
the support has a sapphire substrate.

22. A method for separating a bonded wafer, the method comprises separating a support from a bonded wafer in which a device structure portion is bonded to a support via cured layer using a curable bonding material,
wherein the device structure portion and the support are separated by irradiating with a laser beam from support side of the bonded wafer.

23. A method for manufacturing a separated device structure portion, the method comprises separating a support from a bonded wafer in which the device structure portion is bonded to a support via a cured layer of a curable bonding material,
wherein the device structure portion and the support are separated by irradiating laser light from the support side of the bonded wafer.

24. A bonded body in which a device structure portion is bonded to a support via a cured material layer of a curable bonding material, wherein the bonded body being used for separating the device structure portion by laser beam irradiation.

25. A method for separating a bonded body in which a device structure portion is bonded to a support via a cured material layer of a curable bonding material, the bonded body being separated from the support body,
wherein the device structure portion and the support are separated by irradiating a laser beam from the support side of the bonded body.

26. A method for manufacturing a separated device structure portion, the method comprises separating a support from a bonded body in which a device structure portion is bonded to the support via a cured material layer of a curable bonding material,
wherein the device structure portion and the support are separated by irradiating a laser beam from the support side of the bonded body.
